# EUROPEAN PATENT SPECIFICATION

(11) **EP 1 264 202 B1**
(45) Date of publication and mention of the grant of the patent: **18.05.2005**
(21) Application number: 00991877.2
(22) Date of filing: 20.10.2000
(51) Int. Cl.: G02B 6/10, H04B 14/04, H01S 3/06, H01S 5/34

(54) **SILICON NANOPARTICLE STIMULATED EMISSION DEVICES**
VORRICHTUNGEN ZUR STIMULIERTEN EMISSION AUS SILIZIUM-NANOPARTIKELN
DISPOSITIFS D'EMISSION STIMULES PAR DES NANOPARTICULES DE SILICIUM

(30) Priority: 22.10.1999 US 426389; 25.10.1999 US 426204
(43) Date of publication of application: 11.12.2002
(73) Proprietor: BOARD OF TRUSTEES OF THE UNIVERSITY OF ILLINOIS, Urbana, Illinois 61801 (US)
(72) Inventor: NAYFEH, Munir, H., Urbana, IL 61801 (US); AKCAKIR, Osman, Urbana, IL 61801 (US); BARRY, Nicholas, Urbana, IL 61801 (US)
(74) Representative: Petri, Stellan
(86) International application number: PCT/US2000/041421
(87) International publication number: WO 2001/031374

(56) References cited:
- EP-A- 0 354 141
- US-A- 3 597 624
- US-A- 5 308 804
- US-A- 5 537 000
- US-A- 5 561 679
- US-A- 5 690 807
- US-A- 5 695 617
- US-A- 5 881 200
- MAKIMURA T ET AL: "LIGHT EMISSION FROM NANOMETER-SIZED SILICON PARTICLES FABRICATED BY THE LASER ABLATION METHOD" JAPANESE JOURNAL OF APPLIED PHYSICS, PUBLICATION OFFICE JAPANESE JOURNAL OF APPLIED PHYSICS. TOKYO, JP, vol. 35, PART 1, no. 9A, 1 September 1996 (1996-09-01), pages 4780-4784, XP000735400 ISSN: 0021-4922
- BRONGERSMA M L ET AL: "Tailoring the optical properties of Si nanocrystals in SiO/sub 2/: materials issues and nanocrystal laser perspectives" MATERIALS AND DEVICES FOR SILICON-BASED OPTOELECTRONICS. SYMPOSIUM, MATERIALS AND DEVICES FOR SILICON-BASED OPTOELECTRONICS. SYMPOSIUM, BOSTON, MA, USA, 1-3 DEC. 1997, pages 213-218, XP001106204 1998, Warrendale, PA, USA, Mater. Res. Soc, USA ISBN: 1-55899-391-6
- BRUS L E ET AL: "Electronic spectroscopy and photophysics of Si nanocrystals. Relationship to bulk c-Si and porous Si" J AM CHEM SOC;JOURNAL OF THE AMERICAN CHEMICAL SOCIETY MAR 15 1995 ACS, WASHINGTON, DC, USA, vol. 117, no. 10, 15 March 1995 (1995-03-15), pages 2915-2922, XP002217210
- TIWARI S ET AL: "A SILICON NANOCRYSTALS BASED MEMORY" APPLIED PHYSICS LETTERS, AMERICAN INSTITUTE OF PHYSICS. NEW YORK, US, vol. 68, no. 10, 4 March 1996 (1996-03-04), pages 1377-1379, XP000582303 ISSN: 0003-6951
- BELOMOIN G ET AL: "OXIDE AND HYDROGEN CAPPED ULTRASMALL BLUE LUMINESCENT SI NANOPARTICLES" APPLIED PHYSICS LETTERS, AMERICAN INSTITUTE OF PHYSICS. NEW YORK, US, vol. 77, no. 6, 7 August 2000 (2000-08-07), pages 779-781, XP000956835 ISSN: 0003-6951
- NAYFEH M ET AL: "HIGHLY NONLINEAR PHOTOLUMINESCENCE THRESHOLD IN POROUS SILICON" APPLIED PHYSICS LETTERS, AMERICAN INSTITUTE OF PHYSICS. NEW YORK, US, vol. 75, no. 26, 27 December 1999 (1999-12-27), pages 4112-4114, XP000902590 ISSN: 0003-6951
- DATABASE COMP [Online] WERWA ET AL.: 'Excitation intensity... of silicon nanoparticles', XP002939045 Database accession no. 1997-233617179-M & PROC. OF 1996 MRD FALL MTG. vol. 452, 06 December 1996, pages 129 - 134
- YAMANI Z. ET AL: 'Excitation of size selected nanocrystallites in porous silicon' APPLIED PHYSICS LETTERS,AMERICAN INSTITUTE OF PHYSICS. NEW YORK, US vol. 72, no. 20, 18 May 1998, pages 2556 - 2558, XP012020246

## Description

The present invention is in the optoelectronics field The invention specifically concerns devices relying on the elemental silicon for stimulated emissions. According to the invention, efficient optical emissions are obtained from elemental silicon in response to electrical or optical excitation. No such capability from elemental silicon has been previously demonstrated, and is produced in the invention through a new class of material, referred to herein as silicon nanoparticles.

### BACKGROUND ART

A wide range of optoelectronic devices require stimulated emissions of light. Stimulated emissions are amplified and controlled light emissions. A trend is toward using optoelectronic signaling to replace signaling which relies upon conduction of electricity. Such optoelectronic signaling depends upon devices which produce stimulated emissions, such as lasers and optical amplifiers. In general, optoelectronic signaling is superior for its speed and immunity to many types of interference which affect electric signaling. It is expected that a significant leap will be realized, for example, with the perfection of computers that utilize optical signals instead of electric signals.

Many current communication systems already rely upon optical signals transmitted through optical fibers. Such systems require generation of stimulated emissions which can be modulated to transmit information. The systems may also rely upon amplification, also known as pumping, of optical signals to account for attenuation of signals over transmitted distances. Computers and communications systems are but two examples of devices which can benefit from use of optical signaling. Generally, any electronic device which uses electrical signaling may benefit from use of optical signaling instead.

There are also classes of devices which are unique to optical emissions. Laser light has many applications ranging from surgical devices, to manufacturing tools, to testing devices. Like the signaling devices, these varied devices require a source of stimulated emissions.

Group III-V semiconductors have been the primary source for obtaining stimulated emissions from a compact, semiconductor scaled devices. Group III-V materials are known as direct semi conductors. Direct semi conductors are devices in which the efficiency is as high as 30%. The Group III-V semiconductors can accordingly respond to electrical excitation with the production of significant stimulated emissions. A Group III-V layer typically forms the essential component of semiconductor devices which require stimulated emissions.

Manufacture of the Group III-V semiconductors is relatively difficult and expensive. The manufacture generally involves reactants and by-products which are hazardous. Often, separate steps and reaction chambers are required to produce the Group III-V materials thereby adding expense to the processes from which the materials are produced. Group III-V materials do not integrate well in silicon devices because of lattice mismatch. Hence integration of optics and silicon electronics is generally not considered possible with Group III-V semiconductors.

Elemental silicon, the widespread basis for electronic devices, is obviously suitable for integration into existing electronic structures. However, element silicon is an indirect semiconductor and therefore does not provide a basis for stimulated emissions. It has an extremely poor emission efficiency due to the fact that it is an indirect gap material. For indirect gap materials, emission of light requires the simultaneous release of a photon and participation of crystal vibrations in the form of phonon emission. This is the primary reason that artisans have looked to the Group III-V materials to provide stimulated emissions in electronic devices. Production of emissions from silicon would have advantages from the standpoint of its abundance as a source, and its relative benign nature compared to the components and by-products of processes used to form the Group III-V materials, and most importantly its potential of optoelectronic integration

Recently, some artisans have caused porous silicon to produce light. It was first discovered in 1990 by Canham. However, stimulated emissions have not been demonstrated from porous silicon despite an abundance of experimentation and papers that have been published on the subject. Moreover, porous silicon is usually only 1-5 percent efficient. This is due, in part, to the fact that elemental silicon sub structure is not small enough and it is typically plagued with impurities and electronic defects that compete very strongly with the radiative process.

An article entitled "Excitation of size selected nanochrystallites in porous silicon" by Yamani et al, Appl. Phys Lett. Vol. 72, page 2558 (1998) discloses that silicon particles having a size below a critical size of 1.4 nm become accessible to resonant excitation.

Morever, an article entitled "Tailoring the optical properties of Si nanocrystals in SiO₂:materials issues and nanocrystal laser perspectives", by Brongersma et al in Material and Devices for Silicon-based Optoelectronics. Symposium, Materials and Devices for Silicon-based Optoelectronics, Symposium, Boston, Ma, USA, 1-3 Dec, 1997, pages 213-218, XP0011 062 04, 1998, Warrendale, PA, USA, Mater, Res. Soc, USA 15BN: 1-55899-391-6, discloses Si nanocrystals having 2-5 nm diameter and showing a broad photoluminiscence spectrum. The article discusses that gain by stimulated emission may be achieved by using silicon nanocrystals with a diameter smaller than about 1,5 nm, with a uniform size distribution.

Accordingly, it is an object of the present invention to provide a heretofore unknown source for stimulated emissions in electronic devices, elemental silicon nanoparticles.

An additional object of the present invention is to provide devices . which produce stimulated emissions from elemental silicon nanoparticles.

### DISCLOSURE OF THE INVENTION

The present invention as defined in claims 1 and 12 relies upon a previously unknown material as an emission source or gain media, silicon nanoparticles. These nanoparticles, having dimensions on the order of one nanometer and not exceeding about two nanometers exhibit qualities unlike bulk or atomic silicon. The silicon nanoparticles may be formed into random geometric structures. The silicon nanoparticles may also be suspended in fluids, incorporated into solids, formed into crystals, and formed into device quality thin films. The nanoparticles thus form the basis for a wide range of novel devices.

The present invention thus provides elemental silicon, in the form of silicon nanoparticles, capable of stimulated emissions as the basis for devices requiring production of stimulated emissions or a gain medium. Silicon particles of the invention produce stimulated emissions as the basis for stimulated emissions in electronic devices. Crystals formed of nanoparticles produce directed emissions, indicating the nanoparticles possess a capability for lasing. Artisans will readily appreciate the broad ranging applicability of the invention as the basis for many devices which utilize stimulated emissions.

### BRIEF DESCRIPTION OF THE DRAWINGS

Other features, objects, and advantages of the invention will be apparent by reference to the detailed description and the drawings, of which:
FIGS. 1a and 1b show microcrystallite stimulated emissions devices according to the present invention;
FIG. 2 shows a liquid silicon nanoparticle colloid laser device according to the present invention;
FIG. 3 shows a solid silicon nanoparticle colloid laser device according to the present invention;
FIG. 4 shows a laser-transistor dual device in which a microcrystallite of nanoparticles that produces stimulated emissions is embedded in the gate area of a Si field effect transistor (MOSFET);
FIG. 5 shows a blue light amplifier device in which a medium of nanoparticles that produces stimulated emissions is pumped by a laser source; and
FIG. 6 illustrates a method for forming silicon nanoparticles.

### BEST MODE OF CARRYING OUT THE INVENTION

The present invention concerns stimulated emission devices which rely upon elemental silicon nanoparticles for stimulated emissions. Semiconductor lasers, optical pumps, and optical sources are exemplary devices of the invention, but artisans will appreciate that other devices are enabled by the elemental silicon stimulated emissions of the invention. Devices of the invention include silicon nanoparticles in communication with a excitation source, which may be electrical or optical. Silicon nanoparticles of the invention produce stimulated emissions.

Referring now to the drawings, there are several types of exemplary stimulated emission devices that can be constructed using the silicon nanoparticle of the invention as a gain media. The type of device will depend on the manner in which the gain media (silicon nanoparticles) are grouped, namely in crystallite, liquid, or solid form. Various types of lasers are discussed below.

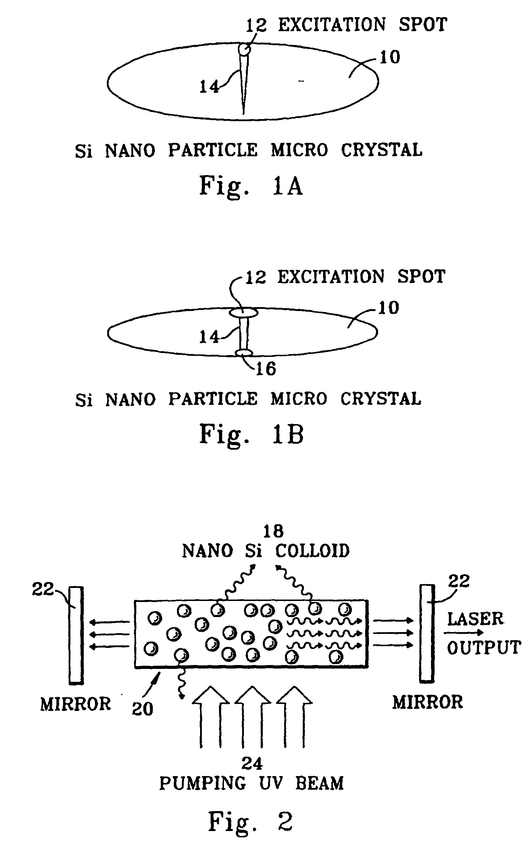

Silicon Microcrystallite Laser. In FIGS. 1a and 1b, colloidal micro crystallites 10 of the silicon nanoparticles are formed on a device quality silicon layer by gentle evaporation from a volatile acetone colloid. The micro crystals are pumped, for example, at an excitation spot 12 by femto-second pulsed or continuous wave radiation at 780 nm. We observed blue laser action in a colloidal crystallite micro cavity, with the sides of the crystallite acting as reflectors. FIG. 1a illustrates a case where the excitation spot 12 is far away from the opposite face, or the crystal faces are insufficiently parallel. A beam 14 fades before reaching the opposite side. In FIG. 1b, with close parallel faces, a well collimated beam 14 emerges at an exit irradiation spot 16. The device may be stimulated optically or electrically.

Liquid Silicon Colloid Laser. The particle gain medium is a liquid colloid 18 of the silicon nanoparticles, as seen in FIG. 2. This is analogous to the well-known concept of dye lasers. For the liquid form, the enrichment of the particles may not yield a high gain media. In this case a cavity consisting ofa long channel 20 of a small diameter "capillary" provides a long pass of the gain media to offset the low particle density. Reflectors 22 provide feedback, focus and direct emissions from the ends of the narrow channel. The device is simulated optically by a pumping beam 24.

Solid Silicon Colloid Laser. The particle gain medium is a solidified colloid 26. The device structure and operation is otherwise the same as in FIG. 2. The silicon colloid may be solidified by applying an electric field to the disordered fluid. Particles take only milliseconds to form long "pearl" chains. A few seconds later, the chains aggregate into columns. Field strength of 1 KV/cm is needed to achieve solidification. Such solidification increases the linear density, hence reduce the single pass length, allowing a more compact cavity than the FIG. 2 device.

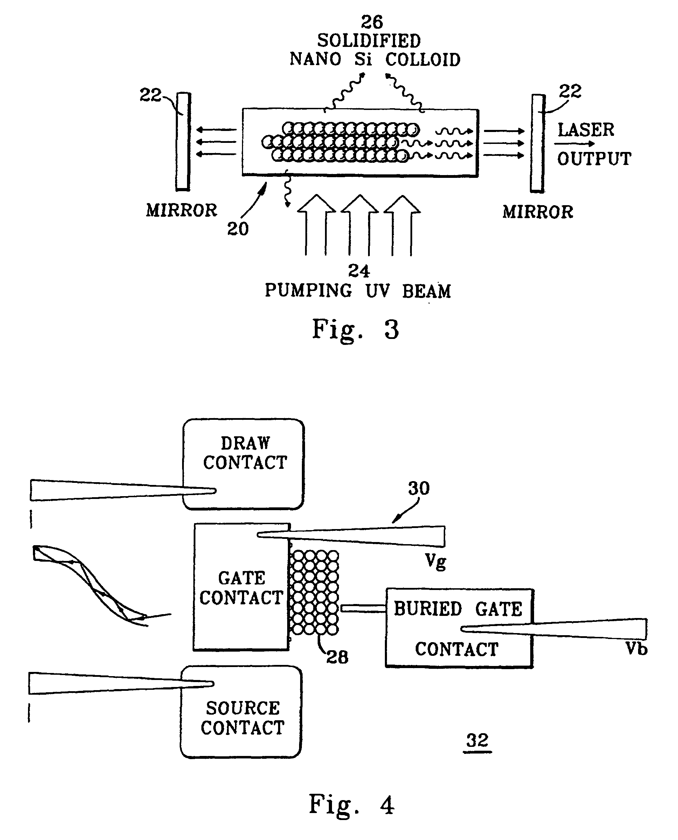

Laser-Transistor Device. This is a dual device where a microcrystallite of silicon nanoparticles 28 is embedded in the gate area 30 of a Si field effect transistor (MOSFET) 32, as shown in FIG 4. The microcrystallite may be photo or electro stimulated to produce blue laser beams within the body of the transistor. At the same time it will operate as a single electronics device, i.e., a single electron flow should produce operation of the transistor. The device can be stimulated optically as well as electrically.

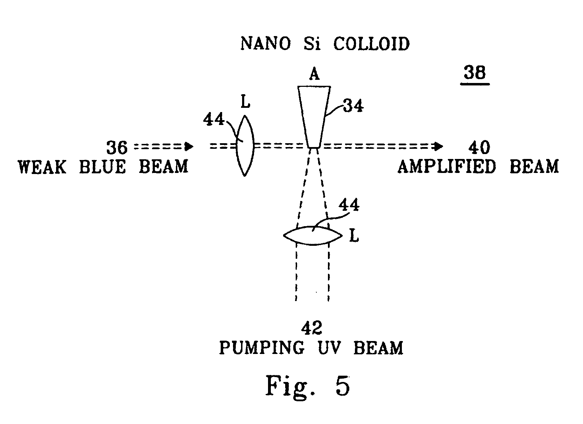

Blue Light Amplifier. In this application, as shown in FIG. 5, the silicon nanoparticle material of the invention is used as a gain media 34 for amplification of a an externally injected weak blue light signal 36. The injected light 36 may be a laser beam generated by one of the above laser designs, or produced by any other type of laser system or light source. The amplifier 38 is basically realized by a silicon nanoparticle colloid as in either of FIGS. 2 or 3. There are no reflectors built into it, though, so it may not produce laser beams on its own. Instead, the signal 3 6 to be amplified traverses the stimulated gain media 34, picking up additional intensity by stimulated emission, and emerges as an amplified beam 40. The device is stimulated optically by a pumping beam 42, which, like the injected beam 36, may be directed by a lens 44.

There are several potential pumping schemes for the devices of FIGS. 1-5. Examples include (I) Pulsed single photon UV excitation (ii) Pulsed two-photon infrared excitation (iii) Continuous wave (CW) excitation (iv) Electron injection or electrical excitation. The basic emission principle of the invention forms a building block from which innumerable more complex devices may be constructed. The device of the invention is suitable to replace any device used as a stimulated emission source in the blue range. However, the device of the invention will also have broader applicability for several reasons.

First, the silicon nanoparticle gain media of the invention is a substantially more efficient source of stimulated emissions than conventional Group III-V sources. Whereas the Group III-V sources produce stimulated emissions at about 30 percent efficiency, the devices of the invention are expected to produce stimulated emissions near 60 percent efficiency.

The gain media of the invention also offers the potential for integration in the silicon electronics device industry. There is a great need for a multi-function chip in which more than one function are performed on the same electronic chip, such as radar transmit/receive or infrared detection coupled with digital processing, or high speed digital processing with electro-optical transmit/receive for interconnection. These different functions require different semiconductor materials which often have significant lattice mismatch between each other and the common substrate. Growing optically active materials such as III-V's on silicon layers, the backbone of electronics is not possible, at least by conventional means, because of the lattice mismatch. Thus integrating III-V or other direct-gap device materials on a silicon wafer is not generally considered feasible.

Although bulk silicon is a poor optical material, the predominance and steadily diminishing cost of Si in the electronics industry has motivated groups worldwide to work towards fabricating novel silicon based structures that might emit light efficiently. The silicon nanoparticles of the invention offer the potential of silicon based integrated opto-electronics, i.e., a marriage of optical and electronic circuits, producing new generations of faster and lower power switches and other components for telecommunications and computers.

Electronic computers use electrons in electric circuits, but the concept of optical computers is based on the use of light instead of electrons. While electronic computers have continued to advance in speed and memory at an exponential rate, doubling their clock rate every few years or so, there are inherent limitations in all electronic devices. First, electrons cannot move through each other nor can electric currents B they must always be directed through wires of some sort. This means, for example, that three-dimensional interconnections: and three-dimensional computers have always been difficult to implement B there would be just too many crossconnecting wires and switches. Yet three-dimensional structures have inherent advantages in density of processing B a 1-cm cubic array of 1-pm transistors could theoretically contain a trillion transistors or the equivalent. In addition, electrons inevitably generate heat as they move through conductors and semiconductors. This heat must be removed and puts potential limits on the density and speed of chips and multiprocessor computers. And, electronic devices operate at speeds far less than the speed of light A typical clock step today is a few nanoseconds, but the time it takes light to get from one end of a chip to the other is a hundred times less.

Light can also travel through free space without the need for wires or fibers, and photons can travel through each other without alteration. Furthermore, energy losses from light traversing free space are negligible, allowing highly energy-efficient devices. And while electro-optic switches can slow down optical computers, some optical computations, again using interference effects, can be performed literally at the speed of light. So optical computers can be designed that are inherently three-dimensional and highly parallel.

However, optical computing has additional serious obstacles. It is difficult to fabricate optic elements that are very small, so most laboratory systems are bench-top-sized, not chip-sized. Given the strengths and weaknesses of optical computing, the initial primary applications of the silicon nanoparticle gain media of the invention in computer devices is not in replacing general-purpose electronic computers, but in narrower niches in which optical advantages are the greatest. And while optical computing can in some cases do what electronic computing does, but better and faster, the truly unique, purely optical capabilities are just now being developed for computing applications.

The most obvious application for optical computing technology are in interconnecting conventional electronic computer chips or boards. Potentially, optical interconnects may vastly increase connectivity and reduce communication times for machines with multiple processors. For example, there is potential in board-to-board interconnects on large-scale parallel processors. In such interconnects, smart-pixel arrays are driven by electronic commands from the parallel processor but use optical switching in free space to do the interconnection. Many of the early versions of such inter-connects used a simple system with five elements. A square array of light sources such as LEDs or laser is focused by a single lens onto a smart-pixel array that is modulated with the output from one board. A second lens images the output of the first array onto a detector array attached to the second board. This is the optical equivalent of hardwired connections.

Silicon particle lasers could become important not only as light emitting devices for their own sake, but also for optical interconnection. As devices become smaller and faster, the circuit speed will eventually be limited by the speed of signals across the interconnecting wires. It is hoped that light waves can replace the wires to speed the processes. Thus it is hoped that the light emitted by the nano crystals may replace conducting wires in conventional silicon electronics. This newly discovered property of silicon may lead to the marriage of optical and electronic circuits that is, between computation and detection, producing new generations of faster and lower power switches and other components for telecommunications and computers

The exemplary stimulated emissions devices discussed herein use optical excitation sources. Electrical excitation is expected to produce similar results. When an electron of sufficient energy strikes a silicon nanoparticle, an electron hole-pair can be excited. Once the excitation is accomplished, the remaining portion of the process, namely trapping and radiative recombination, is the same as in photo excitation, resulting in what is called electro luminescence. Another potential source of excitation is an electron beam from a near field optical microscope.

The invention includes a method for converting silicon bulk crystals into individual silicon nanoparticles. The silicon nanoparticles may also be combined or reconstituted into crystals, solids, films, etc. The method for creating the nanoparticle of the invention is an electrochemical treatment which involves gradually advancing bulk silicon, e.g., a wafer, into a chemical etch bath at a low speed while etching is taking place, in the presence of an external current A meniscus forms as a very thin slice of the silicon that is at the interface of etchant solution and air. The slow advance of the silicon creates a large section which is meniscus-like. In effect, a traveling meniscus is created as the silicon material is gradually advanced into the etchant bath while electrical current is applied. The process enriches the ultra small substructure of the material. Moreover, it makes the top skin of the silicon material extremely fragile. The ultra-small structures, which are silicon nanoparticles, may then be separated from the material and recovered.

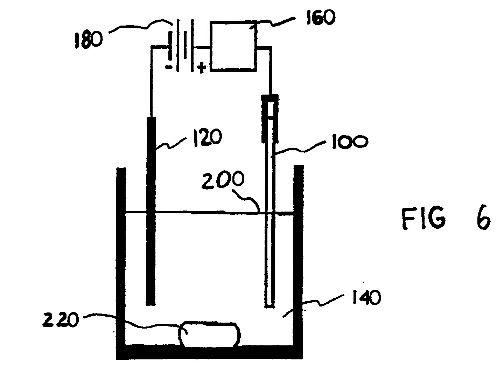

A preferred embodiment of the method is illustrated in FIG. 6. The preferred embodiment uses a silicon single crystalline wafer 100, a platinum cathode 120 in the form of a sheet or a wire, HF acid, H₂O₂ liquid, and other chemicals that might include methanol or water for an etchant bath 140. The preferred silicon wafers are (100) or (111) oriented, 1-10 ohm-cm resistivity, p-type boron-doped silicon.

The wafer 100 and the cathode 120 are connected to a constant current source 160 driven by a power source 180. The cathode 120 is vertically or horizontally immersed in the etchant. The silicon wafer 100 is gradually advanced. By way of example, it has been found that a speed of about 1 mm per hour produces good results. As the silicon wafer 100 is gradually immersed into the solution, at a distance from the cathode 120, a meniscus forms at the point where the silicon wafer 100 is interfaced with a surface 200 of the etchant bath 140. While advancing the wafer, the current is maintained. By way of example, 15 mA has been found to produce good results. A magnetic stirrer 220 ensures that the chemicals of the etchant stay uniformly mixed. The meniscus travels along the silicon wafer 100 due to the gradual immersion and etches to create silicon nanoparticle structures on the top skin of the silicon material. By utilizing H₂O₂ (as a catalyst), and significant current, a high etching rate is realized which produces films of interconnected substructure with much reduced sizes, approaching the limit of size. Moreover, the lateral anodization creates a high current concentration in the top skin of the silicon wafer 100, hence the high etching rate leading to the ultra-small nanoparticle structures, especially at the meniscus (air--liquid interface). Advancing the sample in the etchant slowly and uniformly results in a large area of the sample that is meniscus-like, hence enriching the ultra small nano substructure.

Nanoparticles are then obtained by separating the silicon wafer 100 from the etchant bath 140, and separating the silicon nanoparticles from the surface of the silicon wafer 100. In the preferred method, the silicon wafer 100 is first removed from the etchant bath 140 and rinsed with methanol. In a large scale production of nanoparticles, it may be preferable to drain or move the etchant bath as a manner of separating the etchant bath 140 and silicon wafer 100. The silicon wafer 100 is then preferably immersed in an ultra sound acetone (ethanol, methanol or any other solvent) bath for a brief period of time. Under the ultra sound treatment, the very top layer of the silicon film on the wafer 100, a weakly interconnected luminescent nanostructure network, crumbles into ultra small silicon nanoparticles, leaving behind a bottom layer of a deep red luminescent silicon nanoparticle material. This colloid is left to settle. Larger yellowish/orangish luminescent particles precipitate in a few hours, leaving behind a bluish luminescent colloid. Residual larger clusters with very low abundancy (I part in one thousand) may remain in the colloid. Those can be separated by filtering the colloid using a commercial 200 nm filter, resulting in a highly uniform size distribution. The colloid is stable as shown by the fact that it retains characteristic emission over weeks, indicating that the silicon nanoparticles are small enough to stay in suspension. Generally, any method which separates the silicon nanoparticles from the etched anode is suitable, but the solvent with breaking force supplied by ultrasound waves is preferred. Shaking, scraping or banging are exemplary, non-exhaustive, alternative techniques that may be used to break off the particles. The ultrasound appears to work best, though.

What is left of the silicon wafer 100 can be recycled (used as a source for creating additional nanoparticles) two to three times or even more depending upon its thickness. This cuts the cost of the raw material.

The silicon nanoparticles of the invention have good electronic, chemical and structural qualities. The preferred use of H₂O₂ as part of the etchant solution to produce the silicon nanoparticles provides a high quality hydrogen coating (termination or passivation), dominated by an ideal stretching mode with no di- or tri hydrides that act as nonradiative electronic traps. The high quality coating fully protects the silicon particles from uncontrollable low quality post interactions in the ambient atmosphere that would generate nonradiative traps. Moreover, the preferred etchant leaves no oxygen on the particles. After the electrochemical etching process is complete, the hydrogen coating, however, can be replaced by a high quality oxide coating by post immersion in H₂O₂. This is due to the fact that the high quality nature of the hydrogen termination makes it possible for hydrogen to be substituted with an ultra thin high quality oxide termination. This is a self-limiting process that yields oxide layers of 4 A thick on bulk Si, with a trap density of less than 1/10¹⁴. The oxide coating provides additional protection and hardening against laser damage. The optical properties of the silicon nanoparticles are not compromised by such a high quality oxide termination (passivation). As to the chemical quality, H₂O₂ is an oxidant which will remove nearly every kind of contamination (organic material, metals, alkalines, and metal hydroxides) from silicon surfaces by oxidative dissolution and complex formation.

The invention is not limited to the described embodiments. Various modifications and applications will be apparent to those skilled in the art. Accordingly, the scope of the invention is to be determined by the appended claims.

## Claims

1. A stimulated emissions device including a stimulated emissions source having an excitation source, wherein
silicon nanoparticles (10) having dimensions on the order of one nanometer and not exceeding about two nanometers; and
having one part per thousand or less larger particles;
said silicon nanoparticles (10) being in communication with the excitation source and producing stimulated emissions.

2. The device of claim 1, wherein said silicon nanoparticles are formed into a film.

3. The device of claim 1, wherein said silicon nanoparticles are formed into crystals.

4. The device of claim 1, wherein said silicon are formed into a solidified colloid (26).

5. The device of claim 1, wherein said silicon nanoparticles are formed into a liquid colloid.

6. The device of claim 1, **characterised by** a gain media of said silicon nanoparticles (10);
said excitation source being a source, such as beam (24), that excites said gain media; and
means for injecting light into said gain media to obtain stimulated emissions from the gain media.

7. The device according to claim 6, wherein said gain media comprises a silicon nanoparticle crystallite and said means for directing comprises opposing parallel faces of said silicon nanoparticle crystallite.

8. The device according to claim 6, wherein said gain media comprises a solid silicon nanoparticle colloid and said means for directing comprises mirrors.

9. The device according to claim 6, wherein said gain media comprises a liquid silicon nanoparticle colloid and said means for directing comprises mirrors.

10. The device according to claim 6, wherein said gain media comprises silicon nanoparticle crystallite and said excitation source comprises a FET transistor having the silicon nanoparticle crystallite deposited in a gate region of the FET transistor.

11. The device of claim 1, said device being an optical amplifier, **characterised by**
a gain media of said silicon nanoparticles (10);
said stimulated emissions source being an excitation source (24) for said gain media; and
means for directing an input beam into the gain media.

12. Material for producing stimulated emissions comprising elemental silicon nanoparticles, wherein
said nanoparticles (10) have dimensions on the order of one nanometer and not exceeding about two nanometers, **characterised in that**;
one part per thousand or less of said silicon nanoparticles are larger particles.

13. Use of the material of claim 12 in a stimulated emissions device as a stimulated emissions source.

14. Use of the material of claim 12 in an optical amplifier as a gain media.

15. Use of the material of claim 12 in a FET transistor as a gain media.

16. The device according to any one of claims 1 to 11, in which said stimulated emission is of a wavelength corresponding to blue light.

## Patentansprüche

1. Vorrichtung zur stimulierten Emission, eine stimulierte Emissionsquelle umfassend, die eine Anregungsquelle aufweist, welche
Siliziumnanopartikel (10) aufweist mit Abmessungen in der Größenordnung von einem Nanometer und nicht über ungefähr zwei Nanometer; und
ein Teilchen pro tausend, oder weniger, größere Partikel aufweist;
wobei die genannten Siliziumnanopartikel (10) in Verbindung mit der Anregungsquelle stehen und stimulierte Emission erzeugen.

2. Vorrichtung gemäß Anspruch 1, wobei die genannten Siliziumnanopartikel als ein Film ausgeformt sind.

3. Vorrichtung gemäß Anspruch 1, wobei die genannten Siliziumnanopartikel als Kristalle ausgeformt sind.

4. Vorrichtung gemäß Anspruch 1, wobei die genannten Siliziumnanopartikel als verfestigtes Kolloid ausgeformt sind.

5. Vorrichtung gemäß Anspruch 1, wobei die genannten Siliziumnanopartikel als flüssiges Kolloid ausgeformt sind.

6. Vorrichtung gemäß Anspruch 1, **gekennzeichnet durch** ein Verstärkungsmedium der genannten Siliziumnanopartikel (10);
wobei die genannte Anregungsquelle eine Quelle, wie beispielsweise Strahl (24), ist, welche das Verstärkungsmedium anregt; und
Mittel zur Injektion von Licht in das genannte Medium, um stimulierte Emission vom genannten Verstärkungsmedium zu erhalten.

7. Vorrichtung gemäß Anspruch 6, wobei das genannte Verstärkungsmedium ein Siliziumnanopartikelkristallit umfasst, und die Richtmittel sich gegenüberstehende parallele Flächen aus dem genannten Siliziumnanopartikelkristallit umfassen.

8. Vorrichtung gemäß Anspruch 6, wobei das genannte Verstärkungsmedium ein festes Siliziumnanopartikelkolloid umfasst und wobei die Richtmittel Spiegel umfassen.

9. Vorrichtung gemäß Anspruch 6, wobei das genannte Verstärkungsmedium ein flüssiges Siliziumnanopartikelkolloid umfasst und wobei die Richtmittel Spiegel umfassen.

10. Vorrichtung gemäß Anspruch 6, wobei das genannte Verstärkungsmedium ein Siliziumnanopartikelkristallit umfasst, und die Anregungsquelle einen FET Transistor umfasst, welcher das Siliziumnanopartikelkristallit in einem Gatebereich des FET Transistors deponiert aufweist.

11. Vorrichtung gemäß Anspruch 1, wobei die Vorrichtung ein optischer Verstärker ist, **gekennzeichnet durch**
ein Verstärkungsmedium aus den genannten Siliziumnanopartikeln (10);
wobei die genannte stimulierte Emissionsquelle eine Anregungsquelle (24) für das genannte Verstärkungsmedium ist; und
Mittel zum Richten eines Eingangsstrahles in das Verstärkungsmedium.

12. Material zum Erzeugen von stimulierter Emission, elementare Siliziumnanopartikel umfassend, wobei
die genannten Siliziumnanopartikel (10) Abmessungen in der Größenordnung von einem Nanometer und nicht über ungefähr zwei Nanometer aufweisen, **dadurch gekennzeichnet, dass**
ein Teilchen pro tausend, oder weniger, der genannten Siliziumnanopartikel größere Partikel sind.

13. Anwendung des Materials gemäß Anspruch 12 in einer stimulierten Emissionsvorrichtung als eine stimulierte Emissionsquelle.

14. Anwendung des Materials gemäß Anspruch 12 in einem optischen Verstärker als Verstärkungsmedium.

15. Anwendung des Materials gemäß Anspruch 12 in einem FET Transistor als Verstärkungsmedium.

16. Vorrichtung gemäß einem der Ansprüche 1 bis 11, wobei die stimulierte Emission in einer Wellenlänge ist, die blauem Licht entspricht.

## Revendications

1. Dispositif d'émissions stimulées comprenant une source d'émissions stimulées comportant une source d'excitation, dans lequel
des nanoparticules de silicium (10) ayant des dimensions de l'ordre du nanomètre et ne dépassant pas deux nanomètres environ ; et
comportant une partie pour mille ou moins de particules plus grandes ;
lesdites nanoparticules de silicium (10) étant en communication avec la source d'excitation et produisant des émissions stimulées.

2. Dispositif selon la revendication 1, dans lequel lesdites nanoparticules de silicium sont forcées en un film.

3. Dispositif selon la revendication 1, dans lequel lesdites nanoparticules de silicium sont formées en cristaux.

4. Dispositif selon la revendication 1, dans lequel lesdites nanoparticules de silicium sont formées en un colloïde solidifié (26).

5. Dispositif selon la revendication 1, dans lequel lesdites nanoparticules de silicium sont formées en un colloïde liquide.

6. Dispositif selon la revendication 1, **caractérisé par** un milieu de gain desdites nanoparticules de silicium (10) ;
ladite source d'excitation étant une source, telle qu'un faisceau (24), qui excite ledit milieu de gain ; et
des moyens pour injecter de la lumière dans ledit milieu de gain pour obtenir des émissions stimulées à partir du milieu de gain.

7. Dispositif selon la revendication 6, dans lequel ledit milieu de gain comprend une cristallite de nanoparticules de silicium et lesdits moyens de direction comprennent des faces parallèles opposées de ladite cristallite de nanoparticules de silicium.

8. Dispositif selon la revendication 6, dans lequel ledit milieu de gain comprend un colloïde de nanoparticules de silicium solide et lesdits moyens de direction comprennent des miroirs.

9. Dispositif selon la revendication 6, dans lequel ledit milieu de gain comprend un colloïde de nanoparticules de silicium liquide et lesdits moyens de direction comprennent des miroirs.

10. Dispositif selon la revendication 6, dans lequel ledit milieu de gain comprend une cristallite de nanoparticules de silicium et ladite source d'excitation comprend un transistor FET comportant la cristallite de nanoparticules de silicium déposée dans une région de grille du transistor FET.

11. Dispositif selon la revendication 1, ledit dispositif étant un amplificateur optique, **caractérisé par**
un milieu de gain desdites nanoparticules de silicium (10) ;
ladite source d'émissions stimulées étant une source d'excitation (24) pour ledit milieu de gain ; et
des moyens pour diriger un faisceau d'entrée dans le milieu de gain.

12. Matériau pour produire des émissions stimulées comprenant des nanoparticules de silicium élémentaire, dans lequel
lesdites nanoparticules (10) ont des dimensions de l'ordre d'un nanomètre et ne dépassant pas deux nanomètres environ, **caractérisé en ce qu'**une partie pour mille ou moins desdites nanoparticules de silicium représente des particules plus grandes.

13. Utilisation du matériau selon la revendication 12 dans un dispositif d'émissions stimulées comme source d'émissions stimulées.

14. Utilisation du matériau selon la revendication 12 dans un amplificateur optique comme milieu de gain.

15. Utilisation du matériau selon la revendication 12 dans un transistor FET comme milieu de gain.

16. Dispositif selon l'une quelconque des revendications 1 à 11, dans lequel ladite émission stimulée est d'une longueur d'onde correspondant à la lumière bleue.
